(19) **Europäisches Patentamt**

**European Patent Office**

**Office européen des brevets**

(11) **EP 0 696 848 B1**

(12) **EUROPÄISCHE PATENTSCHRIFT**

(45) Veröffentlichungstag und Bekanntmachung des Hinweises auf die Patenterteilung:
**05.04.2000 Patentblatt 2000/14**

(51) Int. Cl.$^7$: **H03H 17/06**

(21) Anmeldenummer: **94112339.0**

(22) Anmeldetag: **08.08.1994**

(54) **Verfahren zur digitalen Interpolation von Signalen**

Method of digital signal interpolation

Procédé pour l'interpolation d'un signal numérique

(84) Benannte Vertragsstaaten:
**DE FR GB IT NL**

(43) Veröffentlichungstag der Anmeldung:
**14.02.1996 Patentblatt 1996/07**

(73) Patentinhaber:
**Micronas Intermetall GmbH**
**79108 Freiburg (DE)**

(72) Erfinder:
• **Menkhoff, Andreas, Dipl-Ing.**
**D-79098 Freiburg (DE)**

• **Temerinac, Miodrag, Dr.**
**D-79258 Hartheim (DE)**
• **Witte, Otto, Dipl.-Ing.**
**D-79212 Emmendingen (DE)**
• **Winterer, Martin, Dipl.-Phys.**
**D-79194 Gundelfingen (DE)**

(56) Entgegenhaltungen:
**EP-A- 0 387 507         EP-A- 0 401 562**
**EP-A- 0 561 067**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 696 848 B1

**Beschreibung**

Die Erfindung betrifft ein Verfahren zur digitalen Interpolation von Signalen durch Multiplikation verzögerter, mit einem ersten Taktsignal verkoppelter digitaler Eingangswerte mit entsprechenden Gewichtungsfaktoren (= Filterkoeffizienten) und Aufaddierung der multiplizierten Werte, wobei die Gewichtungsfaktoren von einem Zeitdifferenzwert abhängig sind, der durch den Interpolationszeitpunkt und das Zeitraster des ersten Taktsignals bestimmt wird, vergleiche den Oberbegriff des Anspruchs 1.

Derartige Verfahren werden bei Interpolationsfiltern verwendet, die insbesondere als Teilschaltungen in digitalen Schaltungssystemen dienen, bei denen eine beliebige Änderung der Abtastrate von digitalen Signalen erforderlich ist. Systeme, die sich nur mit einfachen ganzzahligen Abtastratenverhältnissen befassen, sind nicht Gegenstand der Erfindung. Bei beliebigen Abtastratenverhältnissen soll das mit einem ersten Takt abgetastete Signal in eine Abtastfolge umgewandelt werden, die mit einem beliebigen zweiten Takt verknüpft ist, der im ungünstigsten Fall sogar ein irrationales Frequenzverhältnis zum ersten Takt aufweist. Auch sollen mit der Erfindung diejenigen Zahlenverhältnisse realisierbar sein, bei denen das kleinste gemeinsame Frequenzvielfache beider Takte bei einer unerwünscht hohen Frequenz liegt.

Aus "IEEE, Transactions of Acoustics, Speech and Signal Processing", Band ASSP-32, Nr. 3, Juli 1984, Seiten 577 bis 591 sind unter dem Titel "Digital Methods for Conversion Between Arbitrary Sampling Frequencies", Autor: T. A. Ramstad, Verfahren zur beliebigen Änderung von Abtastraten beschrieben. Die zugehörigen Schaltungen werden als hybride Systeme bezeichnet, die aus einem ersten Interpolationsfilter mit festem Abtastratenverhältnis und einem zweiten Interpolationsfilter (= analoger Resampler) bestehen. Mit dem zweiten Interpolationsfilter werden die Zwischenwerte bestimmt, die zeitlich beliebig zwischen den festen Abtastwerten des Abtastrasters nach dem zweiten Interpolationsfilter liegen und damit beliebige Abtastratenverhältnisse zulassen. Das erste Interpolationsfilter enthält als Kombination eine Interpolationseinrichtung und ein digitales Filter. Mit der Interpolationseinrichtung, die auch als Überabtasteinrichtung bezeichnet wird, werden "Null"-Werte entsprechend einem Überabtastfaktor N zwischen die ursprünglichen Abtastwerte eingefügt. Mit einer Dezimiereinrichtung werden gegebenenfalls ursprüngliche Abtastwerte unterdrückt. Erst das nachfolgende digitale Filter glättet in beiden Fällen den Verlauf der digitalen Abtastwerte, wobei insbesondere die Sprünge auf die Null-Werte ausgeglichen werden, so daß das Spektrum des Nutzsignals nicht durch höhere Frequenzkomponenten verfälscht wird. Hierzu ist das erste Interpolationsfilter so ausgebildet, daß größere Frequenzbereichslücken in dem sich bis ins Unendliche erstreckende Spektrum gebildet werden. Denn auch bei der Überabtastung gilt, daß sich die Frequenzspektren bei der halben ursprünglichen Abtastfrequenzen und deren Vielfachen spiegeln. Nach der Interpolationseinrichtung und nach dem digitalen Filter ist allerdings von einer neuen Abtastfrequenz - im Folgenden auch erster Abtasttakt genannt - auszugehen, die im ganzzahligen Frequenzverhältnis zur usprünglichen Abtastfrequenz steht. Das digitale Filter entfernt dabei wie angegeben die verbleibenden spektralen Komponenten zwischen dem Nutzsignalband und dem gespiegelten Band bei der neuen Abtastfrequenz und den zugehörigen Frequenzvielfachwerten. Die Funktionsweise des digitalen Filters ist dabei einfach diejenige eines digitalen Tiefpasses, der den Nutzsignalbereich durchläßt und die darüberliegenden Frequenzkomponenten unterdrückt, wobei allerdings entsprechend dem Abtasttheorem die bekannte Spiegelung bei der halben Abtastfrequenz auftritt. Ein digitaler Tiefpaß kann also niemals die Vielfachen der Abastfreqenz unterdrücken.

Die spektralen Komponenten bei der neuen Abtastfrequenz und den Frequenzvielfachwerten müssen für die Realisierung beliebiger Abtastratenverhältnisse durch das zweite, analoge Interpolationsfilter unterdrückt werden. Werden diese Störkomponenten nicht unterdrückt, dann werden bei der Erzeugung beliebiger Abtastratenverhältnisse Störkomponenten im Nutzsignalband erzeugt. Die Theorie des ersten Interpolationsfilters ist hinreichend in "Proceedings of The IEEE", Band 61, Nr. 6, Juni 1973, Seiten 692 bis 702 in dem Aufsatz "A Digital Signal Processing Approach to Interpolation" von R W. Schafer und L. R. Rabiner beschrieben.

Für das zweite Interpolationsfilter gibt T. A. Ramstad in dem oben genannten Aufsatz in "IEEE, Transactions On Acoustics, Speech and Signal Processing" , Juni 1984, Seiten 577 bis 591 folgende Möglichkeiten an:

1. Eine Abtasthalteschaltung - dieses Filter hat einfache Nullstellen in der Mitte der noch verbleibenden spektralen Komponenten bei den der neuen Abtastfrequenz. Dieser Filtertyp wird auch als einfaches Kammfilter bezeichnet.

2. Eine lineare Interpolationsschaltung - dieses Filter hat doppelte Nullstellen in der Mitte der noch verbleibenden spektralen Komponenten bei den Frequenzvielfachwerten der neuen Abtastfrequenz. Damit wird eine wirksamere Unterdrückung der Störanteile als bei der einfachen Abtasthalteschaltung erreicht. Diese erfordert beispielsweise für ein Signal/Rauschverhältnis von 100dB einen Überabtastfaktor N von 200, der durch das erste Interpolationsfilter realisiert werden muß. In der genannten Literaturstelle wird ein "optimales" Interpolationsfilter angegeben, das eine Absenkung des Überabtastfaktors auf einen Wert von 164 ermöglicht. Selbst die Verwendung sehr rechenaufwendiger Lagrange-Interpolationsfilter höherer Ordnung erlaubt keine wesentliche Absenkung der erforderlichen Überabtastung. Sowohl das lineare Interpolationsfilter als auch das Lagrange-Interpolationsfilter zeigen ein Kammfilterverhalten.

Aus EP-A 0 561 067 ist ebenfalls ein Verfahren mit einem hybriden System zur Abtastratenumsetzung bekannt. Dieses System arbeitet allerdings nur mit einem Überabtastfaktor N = 2 und erreicht damit nur einen relativ schlechtes Signal/Rauschverhältnis. Dies ist jedoch zulässig, da dieses System für Videosignalanwendungen gedacht ist. Das zweite Interpolationsfilter ist dabei als Tiefpaß realisiert, der alle Frequenzen oberhalb dem 1,5-fachen Wert der ursprünglichen Abtastfrequenz unterdrückt. Das analoge Tiefpaßverhalten wird mit einem Transversalfilter erreicht, bei dem die Gewichtungsfaktoren der gespeicherten Abtastwerte von einem Zeitdiffererzwert abhängig sind, der im folgenden auch als Inter-Sample-Position bezeichnet wird. Ein derartiger Tiefpaß unterdrückt dabei nicht nur die verbleibenden spektralen Komponenten bei den Frequenzvielfachwerten der neuen Abtastfrequenz sondern den gesamten Spektralbereich oberhalb seiner Sperrflanke. Bei einem vergleichbaren Durchlaß/Sperrverhalten ist ein derartiger Tiefpaß immer aufwendiger zu realisieren als eine entsprechende Kammfilteranordnung. Der Tiefpaß verarbeitet zwar digitale, abgetastete Werte - in seiner Wirkung stellt er jedoch einen analogen Tiefpaß, einen analogen Resampler, dar.

Aus "Journal of Audio Engineering Society", Band 41, Nr. 7/8, 1993, Seiten 539 bis 555 ist von den Autoren R. Adams und T. Kwan unter dem Titel "Theory and VLSI Architectures for Asynchronous Sample-Rate Converters" ein Verfahren für ein Abtastratenwandlungssystem bekannt, das einerseits die Verwendung einfacherer Abtasthalteschaltungen und andererseits die Verwendung von Tiefpaßfiltern als analoge Resampler behandelt. Für einfache Systeme werden wegen des geringen Schaltungsaufwandes Abtasthalteschaltungen empfohlen - für höherwertige Systeme wird dagegen die Verwendung eines Tiefpaßfilters nach dem ersten Interpolationsfilter vorgeschlagen, das den gesamten Frequenzbereich oberhalb des Nutzsignalbereichs unterdrückt.

Aus den bekannten Literaturstellen geht hervor, daß nach der N-fachen Überabtastung und Filterung nach dem ersten Interpolationsfilter im Frequenzspektrum auf jeden Fall Störbereiche vorhanden sind, deren Mittenfrequenzen bei den Frequenzvielfachwerten der neuen Abtastfrequenz liegen. Die Bandbreite jedes Störbereichs ist dabei gleich der doppelten Bandbreite des Nutzsignals. Wenn die Nyquistbedingung für die ursprüngliche Digitalisierung erfüllt ist, dann hat die Bandbreite des Störbereichs im Grenzfall maximal den Wert der ursprünglichen Abtastfrequenz. Die Lage und Bandbreite sämtlicher Störbereiche ist im Frequenzspektrum durch die ursprüngliche Abtastfrequenz und den Überabtastfaktor N definiert. Die N-fache Überabtastung der ursprünglichen Abtastfolge bewirkt, daß die relative Breite der Störbereiche bezogen auf die neue Abtastfrequenz um den Faktor 1/N reduziert wird. Dies erleichtert die Trennung des Nutzsignalbandes vom jeweiligen Störbereich, weil der Übergangsbereich zwischen Durchlaß- und Sperrbereich für das zweite Interpolationsfilter vergrößert wird, wodurch der erforderliche Schaltungsaufwand für das zweite Interpolationsfilter verringert wird. Dies wird jedoch durch einen höheren Aufwand für das Glättungsfilter im ersten Interpolationsfilter erkauft.

In der Regel hat man entweder ein sehr aufwendiges erstes Interpolationsfilter, z.B. durch eine hohe Überabtastung, und ein einfaches zweites Interpolationsfilter, z.B. einen linearen Interpolator, oder aber man hat ein einfaches erstes Interpolationsfilter, z.B. mit einer geringen oder gar keinen Überabtastung, und ein sehr aufwendiges Tiefpaßfilter mit dem der analoge Resampler realisiert wird. In der letzgenannten Literaturstelle werden beispielsweise 16.000 feste Stützstellen für das aufwendige Tiefpaßfilter gespeichert.

Aufgabe der Erfindung ist es daher, für das zweite Interpolationsfilter ein verbessertes Verfahren zur digitalen Interpolation von Signalen anzugeben, welches ein hohes Signal/Rauschverhältnis ermöglicht. Dies soll mit einem möglichst geringen Schaltungsaufwand für das Gesamtsystem aus erstem und zweitem Interpolationsfilter realisiert werden.

Die Lösung der Aufgabe ergibt sich aus den Merkmalen des Anspruchs 1. Vorteilhafte Weiterbildungen der Erfindungen ergeben sich aus den Unteransprüchen.

Die Erfindung besteht darin, daß sich die Signaldämpfung des zweiten Interpolationsfilters im wesentlichen kammfilterartig nur auf die Störbereiche bei den Frequenzvielfachwerten der neuen Abtastfrequenz beschränkt und für die dazwischenliegenden Bereiche einen beliebigen Signalverlauf zuläßt. Dabei weist die Übertragungsfünktion des zweiten Interpolationsfilters bezüglich jedem der Störbereiche mindestens zwei Nullstellen auf, wobei die mindestens zwei Nullstellen in jedem Störbereich nebeneinander liegen oder falls es sich bei den mindestens zwei Nullstellen um eine Nullstelle zweiter Ordnung (= zweiten Grades) handelt, mindestens einem der Störbereiche mindestens eine weitere Nullstelle der Übertragungsfünktion zugeordnet wird. Diese weitere Nullstelle wird vorzugsweise, zur gezielten Verbreiterung des Sperrbereiches, neben die vorhandene Nullstelle zweiter Ordnung gesetzt. Durch die mindestens eine weitere Nullstelle werden ferner bei den zugehörigen Frequenzvielfachwerten weitere Nullstellen erzeugt, die dann in der Regel innerhalb der zugehörigen periodischen Störbereiche liegen. Dadurch wird die Unterdrückung der unerwünschten Frequenzbereich weiter verbessert. Zudem nimmt mit steigenden Frequenzen auch in den Durchlaßbereichen des Kammfilters dessen Dämpfungsverhalten zu, so daß die Lage der Nullstellen innerhalb der Störbereiche dort immer unkritischer wird. Durch die jeweilige Übertragungsfunktion werden die Gewichtungsfaktoren der miteinander zu verknüpfenden Abtastwerte im zweiten Interpolationsfilter bestimmt, wobei die Gewichtungsfaktoren wiederum von dem jeweiligen Zeitdifferenzwert des Abtastzeitpunktes zwischen dem ersten und zweiten Abtastraster abhängig sind.

Die weiteren Nullstellen oder die Modifikation ihrer Position lassen sich durch folgende Verfahren erreichen, wobei die Verfahren miteinander kombinierbar und auch mehrfach aufeinanderfolgend anwendbar sind:

a) die Verwendung einer Abtasthalteschaltung höherer Ordnung - also mit mindestens dreifachen Nullstellen,

b) die Verschiebung und Addition der Impulsantwort im Zeitbereich und Bildung einer resultierenden, neuen Impulsantwort und schließlich

c) die Verschiebung und Multiplikation der Übertragungsfünktion im Frequenzbereich und Bildung einer resultierenden, neuen Impulsantwort, wodurch in jedem Sperrbereich mindesten zwei nebeneinanderliegende Nullstellen erzeugt werden.

Die Verfahren nach a) und b) lassen sich mittels einer besonders geeigneten Filterstruktur, der als Name die Bezeichung "Switchable Time-Continuous FIR" (= STC-FIR) gegeben wird, realisieren.

Der Zeitdifferenzwert bzw. die Inter-Sample-Position definiert einen beliebigen Zeitpunkt zwischen zwei festen Abtastzeitpunkten des ersten Frequenzrasters. Durch das erfindungsgemäße Verfahren läßt sich die weitere bzw. lassen sich die weiteren Nullstellen bezüglich der Störbereiche beliebig positionieren, so daß eine gezielte Störunterdrückung möglich wird. Durch einen seitlichen Versatz der Nullstellen im jeweiligen Störbereich läßt sich der jeweilige Dämpfungsbereich einfach in der Breite modifizieren. Durch gezielte Positionierung weiterer Nullstellen kann man beispielsweise den Überabtastungsfaktor im ersten Interpolationsfilter von N = 200 auf N = 8 reduzieren, wobei das zweite Interpolationsfilter nur 5 Abtastwerte miteinander verknüpfen muß. Unter diesen Bedingungen läßt sich ein Signal/Störverhältnis von 100dB erreichen. Dadurch wird der notwendige Schaltungs-bzw. Programmieraufwand für das Abtastraten-Umwandlungssystem stark reduziert und die Taktfrequenzen bleiben zudem niedrig.

Die Erfindung und vorteilhafte Ausgestaltungen werden nun anhand der Figuren der Zeichnung näher erläutert:

Fig. 1 zeigt schematisch die grundsätzliche Funktionsweise von Verfahren zur beliebigen Abtastratenumsetzung,

Fig. 2 veranschaulicht die Abtastratenumsetzung an einem Signalabschnitt im Zeitbereich,

Fig. 3 zeigt schematisch die Frequenzspektren, die bei der beliebigen Abtastratenumsetzung auftreten,

Fig. 4 zeigt die Impulsantworten von Abtasthaltefunktionen erster, zweiter, dritter und vierter Ordung, gemäß dem ersten Verfahren a),

Fig. 5 zeigt die entsprechenden Übertragungsfünktionen zu den Abtastfunktionen höherer Ordnung,

Fig. 6 zeigt die Impulsantworten gemäß dem zweiten Verfahren b), das eine Verschiebung im Zeitbereich betrifft,

Fig. 7 zeigt die entsprechenden Übertragungsfunktionen zu den Zeitverschiebungen ta = T/2 , T/4 und T/8,

Fig. 8 zeigt ein Beispiel für eine resultierende Übertragungsfunktion gemäß dem dritten Verfahren c), das eine Verschiebung im Frequenzbereich betrifft,

Fig. 9 zeigt die entsprechende Impulsantwort zu der Frequenzverschiebung,

Fig. 10 zeigt schematisch als Blockschaltbild eine Realisierung des zweiten Interpolationsfilters ähnlich einem FIR-Filter,

Fig. 11 zeigt schematisch als Blockschaltbild ein vorteilhaftes Ausführungsbeispiel des Interpolationsfilters mit einer umschaltbaren Matrix,

Fig. 12 zeigt schematisch im Zeitdiagramm die Überführung von einem ersten Abtastraster in ein beliebiges zweites Abtastraster und

Fig. 13 zeigt schematisch wie in einer Matrix die verschiedenen Gewichtungsfaktoren in Abhängigkeit von einem Zeitdifferenzwert gebildet werden.

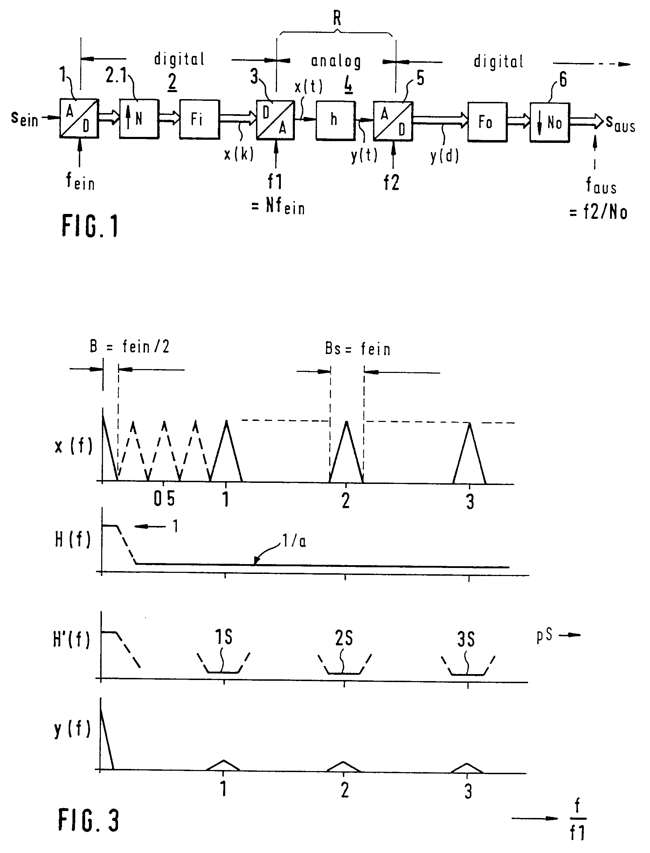

In Fig. 1 ist als Blockschaltbild ein Schema für beliebige Abtastratenumsetzungen dargestellt, wie es üblicherweise zur Erläuterung des Verfahrens verwendet wird. Ein analoges Eingangssignal $s_{ein}$ wird mittels eines Analog-Digitalwandlers 1 digitalisiert, wobei die Digitalisierungsfrequenz $f_{ein}$ ist. Selbstverständlich muß die Nyquist-Bedingung erfüllt sein, so daß sich der Frequenzbereich des analogen Signals $s_{ein}$ höchstens bis zur halben Abtastfrequenz $f_{ein}/2$ erstreckt. Nach dem Analog-Digitalwandler kommt eine Interpolationsstufe 2, welche die ursprüngliche Abtastrate $f_{ein}$

um den Faktor N erhöht. Hierzu werden in der Regel "Null"-Werte zu den zusätzlichen Abtastzeitpunkten als Abtastwerte eingefügt. Durch die Digitalisierung mit der Frequenz $f_{ein}$ spiegelt sich das Nutzsignalspektrum bei der halben Abtastfrequenz $f_{ein}/2$ und wird zwischen den Frequenzwerten $f_{ein}$ und $1,5 \cdot f_{ein}$ wiederholt und so fort, vgl. Fig. 3. Durch die Überabtastung in einem Interpolator 2.1 mit dem ganzzahligen Faktor N ändert sich an dieser periodischen Folge des Signalspektrums nichts. Ein digitales Filter Fi entfernt jedoch aus den Störspektren möglichst alle Frequenzanteile, die zwischen der halben ursprünglichen Abtastfrequenz und dem ersten Störbereich bei der neuen Abtastfrequenz $N \cdot f_{ein}$ und zwischen den weiteren Störbereichen liegen. Damit liegt entsprechend Fig. 3 ein Signal vor, das nur den Frequenzbereich des Nutzsignals enthält und darüber hinaus nur Störanteile, die bei den Vielfachwerten der neuen Abtastfrequenz liegen. Wenn dieses Signal mit einem Digital-Analogwandler 3, der mit der Abtastfrequenz $f1=N \cdot f_{ein}$, arbeitet, zurückgewandelt wird, dann liegt nach einer entsprechenden Glättung angenähert der ursprüngliche Signalverlauf $s_{ein}$ wieder vor. Der Digital/Analog-Wandler 3 erzeugt dabei theoretisch nur zu den unendlich kurzen Abtastzeitpunkten der Frequenz f1 Analogwerte x(t), die durch ein Glättungsfilter h in ein kontinuierliches Signal y(t) umgewandelt werden. Das Glättungsfilter h, das wesentlicher Teil des zweiten Interpolationsfilters 4 ist, kann daher zutreffend auch analoges Interpolationsfilter genannt werden.

Für das Verständnis der Abtastratenumwandlung ist davon auszugehen, daß das Signal y(t) nach dem Glättungsfilter h möglichst dem Eingangssignal $s_{ein}$ gleich ist, das heißt, daß alle Nutzsignalkomponenten vorhanden sind und keine Störsignalkomponenten. Ein unterschiedlicher Skalierungsfaktor ist dabei unerheblich. Wenn diese Bedingungen ideal erfüllt wären, dann könnte mittels einer zweiten Analog-Digital-Wandlereinrichtung 5 das kontinuierliche Signal y(t) mit einem beliebigen zweiten Abtasttakt f2 digitalisiert werden. Die digitalisierten Werte würden eine zweite digitalisierte Abtastfolge y(d) liefern. Wenn das Signal y(d) später mit einer niederen Abtastfrequenz $f_{aus}$ weiter verarbeitet werden soll, dann schließt sich der Digitalisierungsstufe ein digitales Tiefpaßfilter Fo und eine Dezimierstufe 6 an, wodurch der Abtasttakt f2 um das ganzzahlige Frequenzverhältnis No reduziert wird. Dem Ausgangssignal $s_{aus}$ ist die Abtastfrequenz $f_{aus}$ zugeordnet, die sich aus der zweiten Abtastfrequenz f2 mit $f_{aus} = f2/No$, ergibt.

Aus Fig. 1 ist ohne weiteres erkennbar, daß die Genauigkeit der Abtastratenumwandlung im wesentlichen von der Genauigkeit des Signals y(t) abhängig ist, und dieses Signal hängt wiederum von den Eigenschaften des Glättungsfilters h und des digitalen Filters Fi ab. Bei der praktischen Realisierung verzichtet man selbstverständlich auf den analogen Resampler R in der dargestellten Form, weil er eine zusätzliche Digital/Analog- und Analog/Digital-Umsetzung für das analoge Glättungsfilter h erfordert. Es sind nämlich, wie eingangs beschrieben, auch analoge Glättungsverfahren bekannt, die mit einzelnen Abtastwerten auskommen und die erforderlichen Zwischenwerte durch Interpolationverfahren erzeugen. Den einfachsten Fall stellt hierbei die einfache Abtasthalteschaltung (= latch) dar, die den letzten Abtastwert der Folge x(k) so lange festhält, bis der neue Abtastwert vorliegt. Eine Verbesserung bringt der lineare Interpolator, der die beiden letzten Abtastwerte speichert und daraus durch lineare Interpolation einen Zwischenwert zum gewünschten, dazwischenliegenden Interpolationszeitpunkt tP bildet. Andere bekannte Glättungsfilter sind sehr auwendige Tiefpaßfilter oder das Lagrange-Filter. Da bei allen diesen Filtern die Inter-Sample-Position beliebig wählbar ist wird digital auf diese Weise ein analoges Filter realisiert, daher auch die Bezeichnung "analoger Resampler".

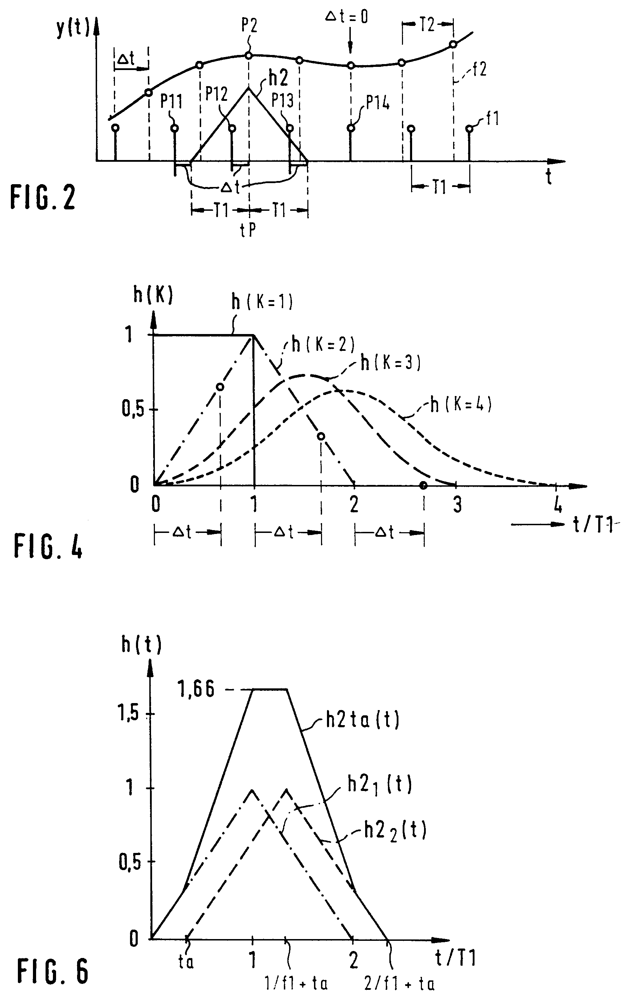

In Fig. 2 ist vereinfacht das kontinuierliche Signal y(t) über der Zeitachse t zusammen mit dem ersten und zweiten Abtastraster f1 bzw. f2 dargestellt. Es soll beispielsweise für den Zeitpunkt tP eine neuer Abtastwert P2 gebildet werden. Mit dem analogen Resampler R nach Fig. 1 erfolgt dies einfach durch den zweiten Analog/Digital-Wandler 5, der vom zweiten Abtasttakt f2 zum Zeitpunkt tP getaktet ist. Ohne den Umweg über den analogen Resampler R muß der Abtastwert P2 jedoch aus benachbarten Abtastwerten P11, P12, P13, P14 der ersten Abtastfolge interpoliert und damit berechnet werden. Der zeitlich unmittelbar vorausgehende Abtastwert P12 und der Interpolationszeitpunkt tP bestimmen dabei einen Zeitdifferenzwert $\Delta t$ (in der folgenden Beschreibung wird hierfür meist die Bezeichnung "dt" verwendet), der zur Berechnung des interpotierten Abtastwertes P2 dient. Bei der linearen Interpolation bestimmt er nämlich den Anteilsfaktor aus den beiden benachbarten Abtastwerten P12 und P13. Für die linearen Interpolation sind die weiteren Abtastwerte P11 und P14 und alle weiteren Werte ohne Interesse. Der Zeitdifferenzwert dt bezieht sich selbstverständlich auf die Periodendauer T1 des ersten Abtasttaktes f1. In der Zeitdarstellung stellt sich die lineare Interpolation als symmetrische, dreiecksförmige Impulsantwort h2(t) im Zeitbereich dar, wobei die Symmetrieachse durch den Interpolationszeitpunkt tP definiert ist. Die zeitliche Breite der Impulsantwort h2(t) umfaßt dabei zwei Abtastperioden T1 und damit zwei gespeicherte Abtastwerte. Der Anteil- oder Gewichtungsfaktor ergibt sich aus dem Schnittpunkt der Abtastwerte P12 und P13 mit der Impulsantwort h2(t). In Fig. 2 fällt der Abtastpunkt P14 es ersten Abtasttaktes f1 mit einem Abtastpunkt des zweiten Abtasttaktes f2 zusammen, so daß dort der Zeitdifferenzwert dt zu Null wird. Die Berechnung des jeweiligen Anteilfaktors ist in allen Fällen unabhängig von der Frequenz des zweiten Abtasttaktes f2. Lediglich der Interpolationszeitpunkt tP ist für die Berechnung maßgebend.

In Fig. 3 sind schematisch einige zu Fig. 1 gehörende Frequenzspektren dargestellt. Das Nutzsignal hat entsprechende dem Nyquist-Kriterium höchstens die Bandbreite $B=f_{ein}/2$. Dem entspricht eine doppelt so große Bandbreite Bs bei den Störbereichen 1S, ..., pS, die mittig zu den Frequenzvielfachwerten des ersten Abtasttaktes f1 liegen. In der ersten Zeile sind gestrichelt die Frequenzspektren angedeutet, die zwischen dem Nutzsignalband und den jeweiligen Störbereichen liegen und die infolge der Spiegelung an der halben ursprünglichen Abtästfrequenz $f_{ein}/2$ entstehen. Durch die Überabtastung mit dem Faktor N ändert sich dabei nichts. Die gestrichelten Frequenzbereiche sollen jedoch möglichst gut durch das digitale Filter Fi unterdrückt werden. Das digitale Filter Fi ist damit ein typischer digitaler Tiefpaß, dessen Frequenz sich bei der halben Abtastfrequenz f1/2 spiegelt.

In der zweiten Zeile stellt Fig. 3 den Frequenzverlauf und damit die Übertragungsfunktion H(f) im Frequenzbereich eines möglichst idealen - und damit analogen - Tiefpasses dar, der als Interpolationsfilter 4 alle Störsignale oberhalb des Nutzsignalbandes B unterdrückt. In der darunterliegenden Zeile wird der gewünschte Frequenzverlauf H'(f) eines Glättungsfilters h dargestellt, bei dem kammfilterartig nach der Erfindung im wesentlichen nur die periodischen Störbereiche 1S, 2S, ..., pS, .... unterdrückt werden. Der Dämpfungsverlauf in den dazwischenliegenden Bereichen ist unerheblich, wenn sie vom digitalen Filter Fi vorher genügend unterdrückt worden sind. In der letzten Zeile wird schematisch die spektrale Verteilung y(f) des interpolierten Signals y(t) dargestellt, die bei den einzelnen Störbereichen nur noch kleine Signalreste enthält, die kleiner als das gewünschte Signal/Rauschverhältnis sein sollen. Anstatt der Bezeichung H(f) wird insbesondere in den nachfolgenden Gleichungen die gleichwertige Bezeichnung H(ω) verwendet mit $ω = 2 \cdot π \cdot f$ .

Bisher ging man bei derartigen Interpolationsschaltungen von der Vorstellung aus, daß für hochwertige Systeme möglichst ein hochwertiger Tiefpaß als analoger Resampler R verwendet werden muß, der alle Signalanteile oberhalb des Nutzsignalbandes B unterdrückt. Nach der Erfindung werden jedoch für die Filterung der digitalen Signale im zweiten Interpolationsfilter 4, das in der Folge vereinfacht als Interpolationsfilter bezeichnet wird, Filterverfahren herangezogen, die sich im wesentlichen kammfilterartig nur auf die Störbereiche beschränken. Maßnahmen der Filterverbesserung, die entsprechend der Erfindung diesen Weg beschreiten, haben eine sehr hohe Effektivität bei der Verbesserung der Gesamteigenschaften des Systems zur Folge. Kleinere Einbußen im Übertragungsverhalten des Nutzsignalbandes sind dabei im Vergleich zu den Verbesserungen im Signal/Rauschverhältnis vernachlässigbar. Auch ist es für das erfindungsgemäße Verfahren nicht wichtig, daß die ursprünglichen Abtastwerte auch nach der Interpolation exakt Teil des Signalverlaufs y(t) sind, wie dies beispielsweise bei dem Lagrange-Verfahren der Fall ist.

In Fig. 4 sind schematisch im Zeitbereich die Impulsantworten h(K=1) bzw. h(K=2) der Abtasthaltefunktionen erster und zweiter Ordnung K = 1 bzw. K = 2 dargestellt, die der bekannten Abtasthalteschaltung bzw. dem bekannten linearen Interpolator entsprechen. Zusätzlich sind die Impulsantworten h(K=3) bzw. h(K=4) für Abtasthalteschaltung dritter bzw. vierter Ordnung K=3 bzw. K=4 dargestellt, mit denen das erfindungsgemäße Verfahren realisiert werden kann. Aus der Darstellung geht auch hervor, daß je nach der Ordung K der Abtasthaltefunktion das Verknüpfungsfenster ein bzw. zwei bzw. drei bzw. vier Abtastwerte des ersten Abtastrasters erfaßt, die im Interpolator 4 gespeichert werden müssen. Die zugehörigen Gewichtungsfaktoren werden aus dem Zeitdifferenzwert dt und dem Schnittpunkt mit der jeweiligen Impulsantwort ermittelt.

Die Impulsantwort einer Abtasthalteschaltung der n-ten Ordung hn(t) ist durch folgende Formel definiert:

$$hn(t) = \frac{1}{(n-1)!} \times \sum_{k=0}^{n} \left[ \binom{n}{k} \times (-1)^k \times (t-kT1)^{n-1} \times σ(t-kT1) \right]$$

dabei bedeuten:

-    "n" in hn(t) die Ordnung der mittigen Nullstellen der zugehörigen Übertragungsfunktion Hn(f) in jedem Störbereich 1S, 2S, ...,pS,... ,
-    "k" ein laufender Zahlenwert für die Addition, der die Werte Null bis n annimmt,
-    "$\binom{n}{k}$" stellt den zugehörigen Binominalkoeffizienten dar und
-    "σ(t)" bzw. "σ(t-kT1)" steht für einen Einheitssprung zum Zeitpunkt t bzw. einen um k Takte verschobenen Einheitssprung zum Zeitpunkt t-kT1.

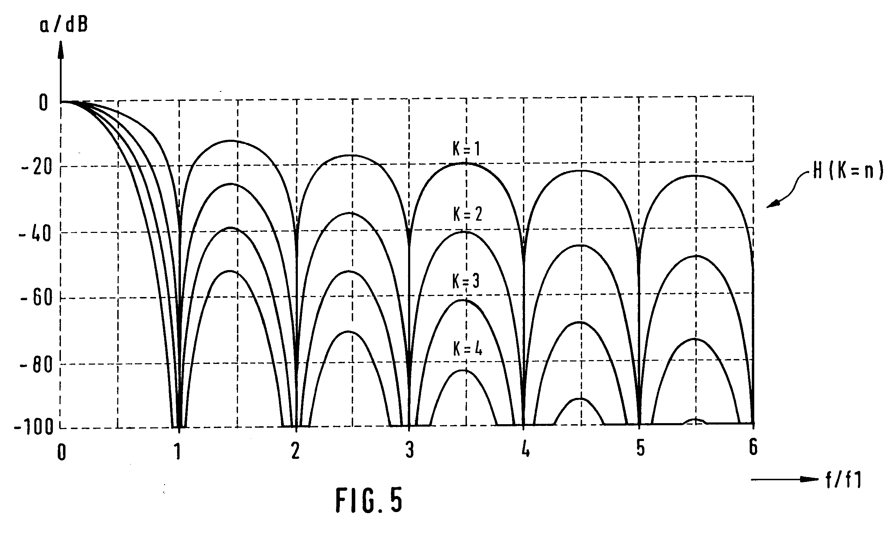

Der entsprechende Frequenzverlauf einiger Übertragungsfünktionen H(k=n) ist in Fig. 5 dargestellt. Mit dem Parameter K wird der Frequenzverlauf für eine Abtasthalteschaltung mit 1 bis 4 Nullstellen dargestellt. Je größer die Anzahl K der Nullstellen ist, desto größer wird die Dämpfüng in den Sperrbereichen. Bei der Betrachtung eines vorgegebenen Signal/Rauschverhältnisses, z.B. bei 80 dB, ist erkennbar, daß sich mit steigender Anzahl K an Nullstellen die jeweiligen Sperrbereiche verbreitern. Unabhängig davon nehmen bei festem K-Wert die Sperrbereiche in ihrer Breite mit steigenden Frequenzen zu. Am kritischsten für das Störverhalten sind die Störbereiche bei niederen Frequenzen. Diese können jedoch nach dem vorbeschriebenen Verfahren gezielt mit zusätzlichen Nullstellen versehen werden.

Nach dem erfindungsgemäßen Verfahren ist es möglich, jede Impulsantwort h(t) so zu verändern, daß mindestens eine weitere Nullstelle durch eine Zeitverschiebung gezielt positioniert werden kann. Aus dem Verschiebungssatz der Fouriertransformation ergibt sich

$$f(t - ta) \; o\Rightarrow \; e^{-j\omega ta} \cdot F(\omega)$$

und durch Addition mit der ursprünglichen Funktion f(t) folgt:

$$f(t) + f(t - ta) \; o\Rightarrow \; 2e^{-j\omega ta/2} \cdot \cos(\omega ta/2) \cdot F(\omega)$$

Diese Formel enthält eine cosinus-Funktion $\cos(ta \cdot \omega / 2)$, die periodische Nullstellen aufweist. Da in der Formel der fouriertransformierte Signalverlauf $F(\omega)$ mit der cosinus-Funktion $\cos(ta \cdot \omega / 2)$ multipliziert wird, weist das Produkt sowohl die Nullstellen von $F(\omega)$ als auch diejenigen der cosinus-Funktion auf. Durch die Vorgabe der Zeitverschiebung ta kann die erste Nullstelle der cosinus-Funktion so gelegt werden, daß $\omega = \omega_{stör}$ ist. Dies ist der Fall für $ta = 1 / 2f_{stör}$.

Die neue Impulsantwort h(t), die von der ursptunglichen Impulsantwort $h_{alt}(t)$ ausgeht, erhält man nach dieser Betrachtung durch die additive Kombination der beiden zeitverschobenen ursprünglichen Impulsantworten nach folgender Beziehung:

$$h(t) = h_{neu}(t) = h_{alt}(t) + h_{alt}(t - ta).$$

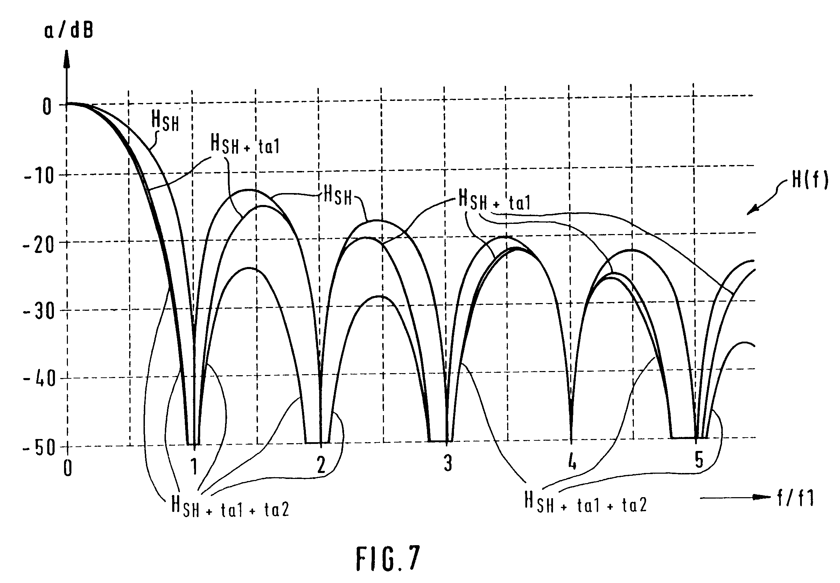

Nach diesem Verfahren wird die resultierende Impulsantwort $h(t) = h2ta(t)$ von Fig. 6 aus einer Überlagerung von zwei zeitverschobenen Impulsantworten $h2_1(t)$ und $h2_2(t)$ eines linearen Interpolators h(K=2) gebildet. Das angewandte Überlagerungsverfahren ist eine Addition der beiden ursprünglichen Impulsantworten zur neuen Impulsantwort h2ta(t). Das Abtastfenster der neuen Funktion ist größer geworden und kann bis zu drei Abtastwerte der ersten Abtastfolge x(k) erfassen. Selbstverständlich können beliebige Impulsantworten h(t) der gleichen Operation unterworfen werden, um gezielt weitere Nullstellen zu positionieren. So kann beispielsweise die resultierende Impulsantwort von Fig. 6 ihrerseits wieder mit einer gleichen, zeitverschobenen Impulsantwort kombiniert werden, um eine zweite zusätzliche Nullstelle gezielt zu positionieren.

Zum Beispiel sind drei Übertragungsfunktionen einer Abtasthalteschaltung für verschiedene Zeitverschiebungen in Fig. 7 dargestellt. Als Referenz dient die einfache Abtasthalteschaltung erster Ordung $H_{SH}$. Nach einer ersten zeitlichen Verschiebung um $ta = ta1$ ergibt sich der mit $H_{SH+ta1}$ dargestellte Kurvenverlauf. Nach einer zweiten zeitlichen Verschiebung um $ta = ta2$ ergibt sich der mit $H_{SH+ta1+ta2}$ dargestellte Kurvenverlauf.

Beispielsweise wird mit einer ersten zeitlichen Verschiebung von $ta = T1 / 2$ die Anzahl aller Nullstellen der ungeraden Störstellen verdoppelt. Diese Störstellen enthalten jetzt jeweils zwei Nullstellen anstatt der ursprünglichen einen Nullstelle. Bei einer nochmaligen Anwendung der zeitlichen Verschiebung, aber nun mit $ta = T1 / 4$ wird jeweils eine weitere Nullstelle bei bestimmten periodischen Störstellen, die bei den geradzahligen Frequenzvielfachwerten 2f1, 6f1, 10f1, ... liegen, ergänzt - jeder dieser Störbereiche weist damit ebenfalls zwei Nullstellen anstatt der ursprünglichen einen Nullstelle auf.

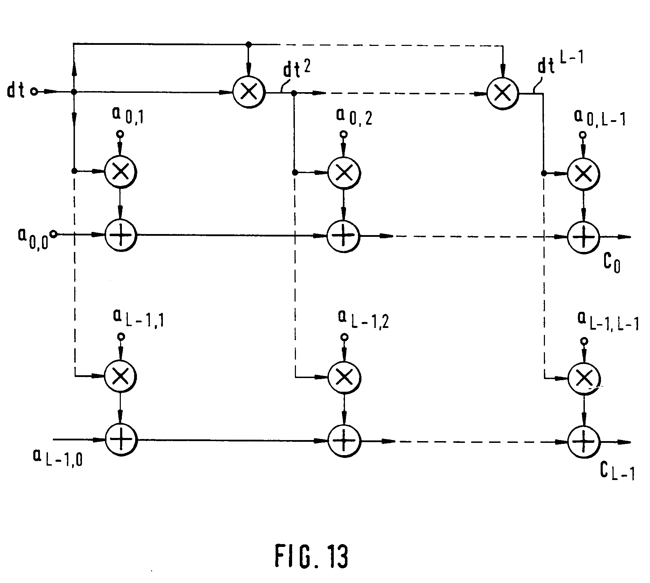

Das dritte, oben genannte Verfahren c) zur Unterdrückung der Störbereiche ergibt sich, wenn in jedem Störbereich einzelne Nullstellen nebeneinander, insbesondere in äquidistanter Anordnung, durch eine Verschiebung im Frequenzbereich positioniert werden. Dadurch wird die relative Breite der Dämpfungszonen bei den Frequenzvielfachwerten von f1 vergrößert, wodurch die erforderliche Überabtastung reduziert werden kann. Fig. 13 zeigt hierzu im Frequenzdiagramm ein Beispiel. Die Übertragungsfunktion $H1(\omega)$ einer Abtasthalteschaltung erster Ordnung wird dabei so modifiziert, daß eine neue Übertragungsfunktion $H_{neu}(\omega)$ als Produkt von zwei im Frequenzbereich verschobenen ursprünglichen Übertragungsfunktionen $H_{alt}(\omega)$ gebildet wird:

$$H_{neu}(\omega) = H2(\omega) = H1_{alt}(\omega - \Delta\omega) \cdot H1_{alt}(\omega + \Delta\omega)$$

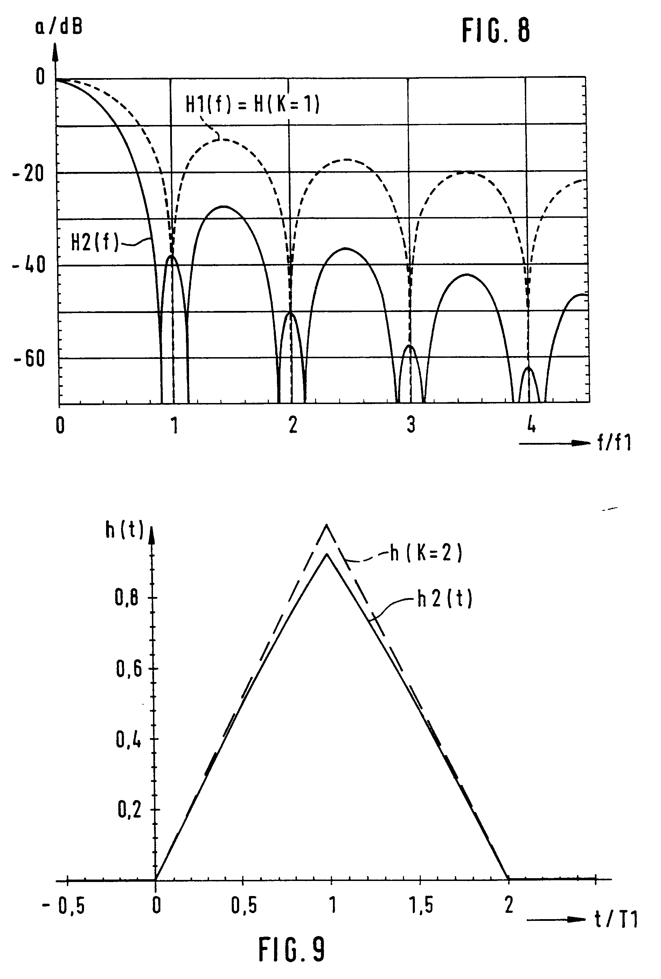

Dadurch wird das Dämpfungsverhalten in sämtlichen Störbereichen so geändert, daß die jeweiligen Dämpfungszonen bei den Frequenzvielfachwerten von f1 relativ breit sind. Obwohl das Durchlaßverhalten von H2(f) in Fig. 8 bei den Frequenzvielfachwerten von f1 ein relatives Maximum aufweist, wird die Störsignalunterdrückung im ersten Störbereich nie schlechter als etwa - 40 dB. Im zweiten Störbereich liegt die Störsignalunterdrückung bereits unter - 50 dB. Soll die Störsignalunterdrückung weiter verbessert werden, dann ist es erforderlich die Übertragungsfunktion H(f) = H3(f) so zu modifizieren, daß jeweils eine dritte Nullstelle genau in der jeweiligen Störbereichsmitte positioniert wird:

$$H3(\omega) = H1(\omega) \cdot H2(\omega)$$

Gegebenenfalls werden eine vierte und fünfte Nullstelle zwischen die vorhandenen Nullstellen gesetzt und so weiter. Dies ist mit dem nachfolgend beschriebenen Verfahren möglich. Die resultierende Impulsantwort h2(t) wird durch eine Fourier-Rücktransformation wie folgt gebildet:

$$h2(t) = \sin(t\omega1) / \omega1 \cdot \sigma(t) + \{\sin[(2T1-t) \cdot \omega1] - \sin(t\omega1)\} / \omega1 \cdot \sigma(t-T1) + \sin[(2T1-t) \cdot \omega1] / \omega1 \cdot \sigma(t-2T1)$$

Die zugehörige Impulsantwort h2(t) zeigt Fig. 9. Sie hat eine große Ähnlichkeit mit der Impulsantwort h(K=2) des linearen Interpolators - sie hat etwa die Form eines gleichschenkligen Dreiecks, aber die beiden Schenkel sind, anders als beim linearen Interpolator h(K=2), leicht konvex gekrümmt. Dies ist durch die oben beschriebene sinus-Funktion der Impulsantwort bedingt.

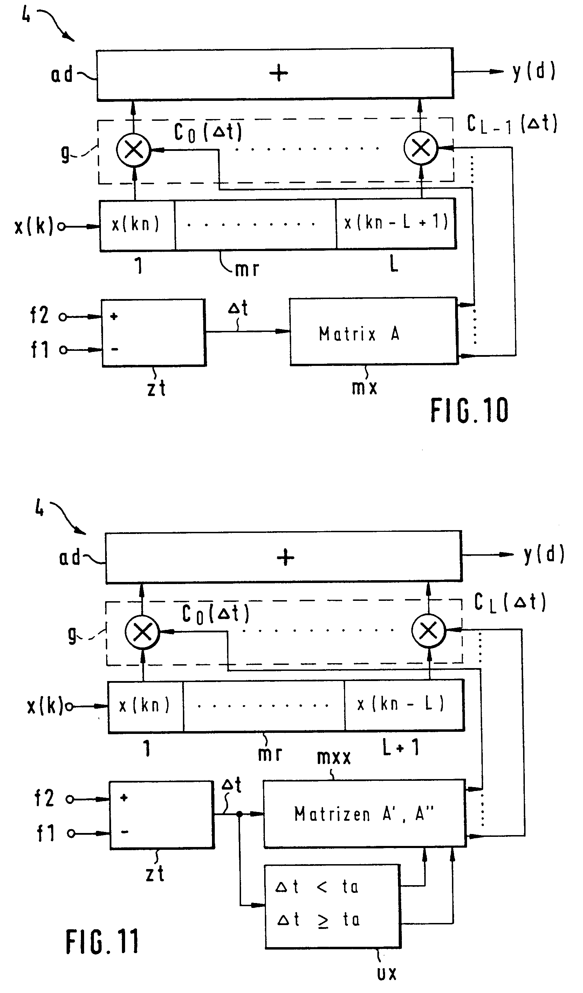

In Fig. 10 ist schematisch als Blockschaltbild eine Anordnung zur Realisierung des Interpolationsfilters 4 dargestellt. Die Anordnung entspricht bekannten Transversalfilteranordnungen mit zeitabhängigen Koeffizienten. Sie enthält eine Speichereinrichtung mr, die eine bestimmte Anzahl 1 bis L bzw. kn bis kn-L+1 Abtastwerte des ersten Abtastrasters x(k) speichert und diese Werte mittels einer Gewichtungseinrichtung g mit Gewichtungsfaktoren $C_0$ bis $C_{L-1}$ multipliziert und in einer Addiereinrichtung ad aufaddiert.

Die Bildung der jeweiligen Gewichtungsfaktoren ergibt sich aus der zeitverschobenen Impulsantwort nach folgender Gleichung:

$$C_l(dt) = h(l \cdot T1 + dt) \text{ mit } l = 0, 1, 2, ..., L-1$$

Im Unterschied zu den bekannten Verfahren werden nach der Erfindung die zeitabhängigen Gewichtungsfaktoren (= Koeffizienten) nicht einer gespeicherten Tabelle entnommen oder mittels einer umfangreichen Berechnung ermittelt, sondern auf einfache Weise mittels einer Matrix mx gebildet, deren Schaltung in Fig. 13 ausführlich dargestellt ist. Diese Realisierung ist nur für die Impulsantworten nach den erfindungsgemäßen Verfahren a) und b) möglich, weil diese abschnittsweise polynominelle Funktionen liefern.

Der Zeitdifferenzwert dt wird einer Matrixstufe mx zugeführt, in der alle Komponenten der Gewichtungsfaktoren Ci bzw. $C_l$ matrixförmig gebildet werden. Die einzelnen Matrixwerte, z.B die Konstanten $a_{0,0}$ bis $a_{L-1,L-1}$ Fig. 13, werden aus einer Speichereinrichtung ausgelesen und mit dem jeweiligen Zeitdifferenzwert dt bzw. mit der entsprechenden Potenz von dt, $dt^2$, $dt^3$, ... multipliziert und aufaddiert und bilden schließlich die zeitabhängigen Gewichtungsfaktoren $C_0(dt)$ bis $C_{L-1}(dt)$.

In Fig. 11 ist eine besonders vorteilhafte Schaltungsanordnung für das Interpolationsfilter 4 dargestellt, bei dem zusätzlich eine Umschalteinrichtung ux und eine erweiterte Matrixstufe mxx vorhanden ist. Dieses Ausführungsbeispiel des Interpolationsfilters 4 erweist sich dann von Vorteil, wenn die Übertragungsfunktion H(f) eine zusätzliche Nullstelle nach dem zweiten Verfahren b erzielen soll. Zum Beispiel lassen sich die beiden linearen Abschnitte des linearen Interpolators abschnittsweise jeweils als Gerade beschreiben. Dies erleichtert den Aufwand für die Berechnung der jeweiligen Gewichtungsfaktoren. In Fig. 11 enthält die Matrixstufe mx beispielsweise die beiden Matrizen A' und A'', denen die Abschnittsbereiche dt < ta und dt ≥ ta entsprechen. In Fig. 6 ist beispielsweise eine Impulsantwort h2ta(t) dargestellt, die abschnittsweise aus geraden Stücken zusammengesetzt ist. Die gespeicherten Abtastwerte in Fig. 11 umfassen L+1 Abtastwerte von 1 bis L+1. Ihnen entsprechen die gespeicherten Abtastwerte x(kn) bis x(kn-L).

Am Beispiel der modifizierten Impulsanwort h2ta(t) von Fig. 6 soll die Bestimmung der Gewichtungsfaktoren $C_0$, $C_1$, $C_2$ entsprechend dem Zeitdifferenzwert dt erläutert werden, wobei die Berechnung abschnittsweise erfolgen soll. Dazu wird die Impulsantwort h2ta(t) in fünf Abschnitte zerlegt. Außerhalb dieser Abschnitte hat die Impulsantwort den Wert Null.

| 1. Abschnitt von | 0 < t < ta : | h(t) = t |
|---|---|---|
| 2. Abschnitt von | ta < t < 1 : | h(t) = - ta + 2t |
| 3. Abschnitt von | 1 < t < 1+ta : | h(t) = 2 - ta |
| 4. Abschnitt von | 1+ta < t < 2 : | h(t) = 4 + ta - 2t |
| 5. Abschnitt von | 2 < t < 2+ta : | h(t) = 2 + ta - t |

Für die nachfolgende Berechnung der Gewichtungsfaktoren gelten folgende Gleichungen:

$$C_l(dt) = h(l + dt) \text{ mit dem laufenden Parameter } l = 0, 1, 2, ... \text{ und}$$

$$h(t) = h_{alt}(t) + h_{alt}(t - ta)$$

Die Impulsantwort h2ta(t) hat bei den Frequenzwerten 0f1, 1f1 und 2f1 jeweils eine Unstetigkeitsstelle. Da auch bei den Zeitwerten 0+ta, T1+ta und 2T1+ta jeweils eine Unstetigkeit vorliegt, ist die mathematische Beschreibung der geraden Zwischenstücke bis zum jeweiligen Zeitwert ta abschnittsweise viel einfacher. Dies zeigen die obigen fünf einfachen Impulsantworten h(t). Sie liefern folgende Gewichtungsfaktoren fuhr die fünf möglichen Zeitbereiche von dt innerhalb der Impulsantwort:

| 0 < dt < ta | bzw. | ta < dt < 1 |
|---|---|---|
| $C_I(dt) = dt$ | | $C_I(dt) = -ta + 2dt$ |
| $C_I(dt) = 2 - ta$ | | $C_I(dt) = 2 + ta - 2dt$ |
| $C_I(dt) = ta - dt$ | | $C_I(dt) = 0$ |

Dies ergibt für die Matizen A' und A'' folgende umschaltbare Koeffizienten oder Matrixwerte, die als Faktoren für die nachfolgende Multiplikation bzw. als zeitunabhängiger Wert einer Speichereinrichtung entnommen werden:

$$A' = \begin{bmatrix} 0 & 1 \\ 2\text{-ta} & 0 \\ ta & -1 \end{bmatrix} \qquad A'' = \begin{bmatrix} \text{-ta} & 2 \\ 2\text{+ta} & -2 \\ 0 & 0 \end{bmatrix}$$

Für das dritte Verfahren c) mit der Verschiebung im Frequenzbereich ist die Berechnung der Gewichtungsfakoren nicht mehr mittels einer Matrixanordung wie in Fig. 10 oder Fig. 11 möglich, sondern sie erfordert eine Berechung von sinus-Werten oder eine Entnahme dieser Werte aus einer gespeicherten sinus-Tabelle. Denn die erforderlichen sinus-Werte lassen sich nicht durch eine einfache Polynomreihe approximieren - in diesem Falle würde man direkt die Polynomreihe und damit die Matrixlösung verwenden.

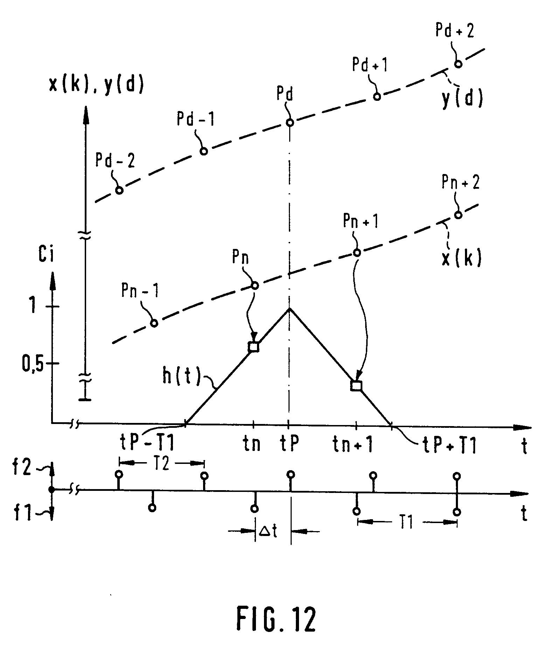

In Fig. 12 ist etwas ausführlicher als in Fig. 2 dargestellt, wie aus einer ersten Abtastfolge x(k) eine zweite Abtastfolge y(d) mit beliebigem Frequenzverhältnis erzeugt wird. Der gesuchte Abtastwert Pd, der zu dem Interpolitions- oder Abtastzeitpunkt tP gehört, wird durch eine, insbesondere polynominelle, Interpolation aus der ersten Abtastfolge x(k) gebildet. Hierzu wird der Zeitdifferenzwert dt aus dem nächstliegenden Abtastwert Pn der ersten Abtastfolge x(k) und dem gewünschten Abtastzeitpunkt tP bestimmt. Entsprechend diesem Zeitdifferenzwert tP werden die Gewichtungsfaktoren Ci aus der Übertragungsfunktion h(t) ermittelt. Durch die Speichereinrichtung mr wird dabei sichergestellt, daß die erforderlichen Abtastwerte Pn und Pn+1 für die Interpolationsberechnung von Pd zur Verfügung stehen. Die Berechnung der vorausgehenden und nachfolgenden Abtastwerte Pd-2 bis Pd+2 erfolgt auf ähnliche Weise durch Verschiebung des Interpolationsfensters und Bestimmung des jeweiligen Zeitdifferenzwertes dt.

**Patentansprüche**

1. Verfahren zur digitalen Interpolation von Signalen durch Multiplikation verzögerter, mit einem ersten Taktsignal (f1) verkoppelter Eingangswerte (x(k)) mit entsprechenden Gewichtungsfaktoren (Ci; $C_I$) und Aufaddierung der multipli-zierten Werte, die von einem Zeitdifferenzwert (Δt; dt) abhängig sind, der durch den Interpolationszeitpunkt (tP) und das Zeitraster des ersten Taktsignals (f1) bestimmt wird, gekennzeichnet durch folgende Merkmale:

   - mittels einer Impulsantwort h(t) im Zeitbereich werden die Gewichtungsfaktoren (Ci; $C_I$) bestimmt, wobei die Übertragungsfunktion H(f) im Frequenzbereich ein Signaldämpfungsverhalten aufweist, das bezüglich der Sperrbereiche im wesentlichen auf die bei den Frequenzvielfachen des ersten Taktsignals (f1) liegenden Störbereiche (1S, 2S, ... pS, ...) beschränkt ist,

   - jedem dieser Störbereiche werden mindestens zwei Nullstellen der Übertragungsfunktion H(f) im Frequenzbereich zugeordnet, wobei

   - die mindestens zwei Nullstellen in jedem Störbereich nebeneinander liegen oder

- mindestens einem der Störbereiche (pS) mindestens eine weitere Nullstelle der Übertragungsfunktion H(f) zugeordnet wird, wenn die zwei Nullstellen als Nullstelle zweiter Ordnung (K=2) aufeinander liegen.

2. Verfahren nach Anspruch 1, dadurch gekennzeichnet, daß eine neue Impulsantwort h(t), deren erste weitere Nullstelle der Übertragungsfunktion H(f) im Frequenzbereich bei einer vorgegebenen Frequenz fn liegen soll, nach folgender Bemessungsregel aus einer ursprünglichen Impulsantwort $h_{alt}(t)$

$$h(t) = h_{neu}(t) = h_{alt}(t) + h_{alt}(t - ta) \text{ mit } ta = 1 / 2fn \text{ gebildet wird.}$$

3. Verfahren nach Anspruch 2, dadurch gekennzeichnet, daß zusätzliche weitere Nullstellen der Übertragungsfunktion H(f) durch eine wiederholte Anwendung des Verfahrens gemäß Anspruch 2 beliebig positioniert werden können.

4. Verfahren nach Anspruch 1, dadurch gekennzeichnet, daß jedem Störbereich (1S, 2S, ..., pS, ...) mindestens eine weitere Nullstelle der Übertragungsfunktion H(f) im Frequenzbereich zugeordnet ist, so daß alle Störbereiche mindestens drei Nullstellen aufweisen.

5. Verfahren nach Anspruch 4, dadurch gekennzeichnet, daß die mindestens drei Nullstellen mittig zu den jeweiligen Störbereichen (1S, ..., pS, ...) bei den Frequenzvielfachwerten (1f1, 2f1, ..., pf1, ...) des ersten Taktsignals (f1) liegen.

6. Verfahren nach Anspruch 5, dadurch gekennzeichnet, daß die Impulsantwort h(t) einer Abtasthaltefunktion hn(t) bzw. h(K=n) mit mittig liegenden Nullstellen, die mindestens die Ordnung K = n = 3 aufweisen, durch folgende Formel definiert wird:

$$hn(t) = \frac{1}{(n-1)!} \times \sum_{k=0}^{n} \left[ \binom{n}{k} \times (-1)^k \times (t-kT1)^{n-1} \times \sigma(t-kT1) \right]$$

dabei bedeuten:

"n" die Ordung der mittigen Nullstellen der Übertragungsfunktion Hn(f),
"k" ein laufender Zahlenwert für die Addition, der die Werte Null bis n annimmt und
"$\sigma(t)$" bzw. "$\sigma(t - kT1)$" einen Einheitssprung zum Zeitpunkt t bzw. zum verzögerten Zeitpunkt t - kT1.

7. Verfahren nach Anspruch 6, dadurch gekennzeichnet, daß aus einer alten Impulsantwort $hn_{alt}(t)$ eine neue Impulsantwort $hn_{neu}(t)$ gemäß einem der Verfahren von Anspruch 2 oder 3 gebildet wird.

8. Verfahren nach Anspruch 1, dadurch gekennzeichnet, daß aus einer ursprünglichen Übertragungsfunktion $H_{alt}(f)$ durch eine Verschiebung im Frequenzbereich um die Frequenzwerte $+ \Delta f$ und $- \Delta f$ eine neue Übertragungsfunktion $H_{neu}(f)$ nach folgender Formel

$$H_{neu}(f) = H_{alt}(f - \Delta f) \cdot H_{alt}(f + \Delta f)$$

gebildet wird, wodurch der jeweilige Sperrbereich gegenüber einer mittigen Nullstellenlage verbreitert wird.

9. Verfahren nach einem der Ansprüche 1 bis 7, dadurch gekennzeichnet, daß zusätzliche Nullstellen der Übertragungsfunktion H(f) durch Wiederholung des Verfahrens gemäß Anspruch 8 erzeugt werden.

10. Verfahren nach einem der Ansprüche 1 bis 7, dadurch gekennzeichnet, daß die Gewichtungsfaktoren ($C_0$, ..., $C_{L-1}$) mittels einer Matrixstufe (mx; mxx) gebildet werden.

11. Verfahren nach einem der Ansprüche 1 bis 7 oder Anspruch 10, dadurch gekennzeichnet, daß die Impulsantwort h(t) für die Berechnung der Gewichtungsfaktoren ($C_i$; $C_l$; $C_0$, ..., $C_{L-1}$) abschnittsweise bezüglich dem Zeitdifferenzwert (dt) definiert ist.

12. Verfahren nach einem der Ansprüche 1 bis 7 und/oder einem der Ansprüche 10 oder 11, dadurch gekennzeichnet, daß die Impulsantwort h(t) mit einer FIR-Filterstruktur realisiert wird, wobei die Gewichtungsfaktoren mittels einer Matrixstufe (mx; mxx) gebildet werden.

**13.** Verfahren nach Anspruch 12, dadurch gekennzeichnet, daß die Gewichtungsfaktoren bei einer abschnittsweise definierten Impulsantwort h(t) mittels einer umschaltbaren Matrixstufe (mxx) gebildet werden.

**Claims**

**1.** A method for digital interpolation of signals by multiplying delayed input values (x(k)) locked to a first clock signal (f1) by corresponding weighting factors (Ci; $C_l$) and adding up the multiplied values, which are dependent on a time-difference value ($\Delta t$; dt) which is determined by the interpolating instant (tP) and the time grid of the first clock signal (f1),
<u>characterized by the following features</u>:

-   The weighting factors (Ci; $C_l$) are determined by means of an impulse response h(t) in the time domain, with the transfer function H(f) in the frequency domain having an attenuation characteristic which, with respect to the stop bands, is limited essentially to the alias regions (1S, 2S, ..., pS, ...) located at the frequency multiples of the first clock signal (f1);

-   each of said alias regions is assigned at least two zeros of the transfer function H(f) in the frequency domain,

-   the at least two zeros in each alias region lying side by side or

-   at least one of the alias regions (pS) being assigned at least one further zero of the transfer function H(f) if the two zeros lie on top of one another as a second-order zero (K=2).

**2.** A method as claimed in claim 1, characterized in that a new impulse response h(t) whose first further zero of the transfer function H(f) in the frequency domain is to be located at a predetermined frequency fn is formed from an original impulse response $h_{old}$ (t) as follows:

$$h(t) = h_{new}(t) = h_{old}(t) + h_{old}(t\text{-}ta) \text{ with ta=1/2fn.}$$

**3.** A method as claimed in claim 2, characterized in that additional further zeros of the transfer function H(f) can be arbitrarily positioned by repeated use of the method according to claim 2.

**4.** A method as claimed in claim 1, characterized in that each alias region (1S, 2S, ..., pS, ...) is assigned at least one further zero of the transfer function H(f) in the frequency domain, so that all alias regions have at least three zeros.

**5.** A method as claimed in claim 4, characterized in that at least three zeros are located at the centers of the respective alias regions (1S, ..., pS, ...) at the frequency multiples (1f1, 2f1, ..., pf1, ...) of the first clock signal (f1).

**6.** A method as claimed in claim 5, characterized in that the impulse response h(t) of a sample-and-hold function hn(t) or h(K=n) with centrally located zeros which are at least of the order K = n = 3 is defined by:

$$hn(t) = \frac{1}{(n\text{-}1)\,!} \times \sum_{k=0}^{n} [\binom{n}{k} \times (\text{-}1)^{k} \times (t\text{-}kT1)^{n\text{-}1} \times \sigma(t\text{-}kT1)]$$

where

| | |
|---|---|
| n = | order of the central zeros of the transfer function Hn(f) |
| k = | running numerical value for addition which assumes the values zero to n |
| $\sigma(t)$ and $\sigma(t - kT1)$ = | unit steps at the instant t and the delayed instant t - kT1, respectively. |

**7.** A method as claimed in claim 6, characterized in that a new impulse response $hn_{new}(t)$ is formed from an old impulse response $hn_{old}(t)$ by either of the methods of claims 2 and 3.

8. A method as claimed in claim 1, characterized in that a new transfer function $H_{new}(f)$ is formed from an original transfer function $H_{old}(f)$ by a shift in the frequency domain by the frequency values $+\Delta f$ and $-\Delta f$ according to the following formula:

$$H_{new}(f) = H_{old}(f - \Delta f) \cdot H_{old}(f + \Delta f),$$

whereby the respective stop band is widened as compared with a central zero position.

9. A method as claimed in any one of claims 1 to 7, characterized in that additional zeros of the transfer function H(f) are generated by repeating the method according to claim 8.

10. A method as claimed in any one of claims 1 to 7, characterized in that the weighting factors $(C_0, ..., C_{L-1})$ are formed by means of a matrix stage (mx; mxx).

11. A method as claimed in any one of claims 1 to 7 or in claim 10, characterized in that for the calculation of the weighting factors $(Ci; C_l; C_0, ..., C_{L-1})$, the impulse response h(t) is defined in sections with respect to the time-difference value (dt).

12. A method as claimed in any one of claims 1 to 7 and/or in claim 10 or 11, characterized in that the impulse response h(t) is implemented with an FIR filter structure, the weighting factors being formed by means of a matrix stage (mx; mxx).

13. A method as claimed in claim 12, characterized in that with an impulse response h(t) defined in sections, the weighting factors are formed by means of a switchable matrix stage (mxx).

**Revendications**

1. Procédé pour l'interpolation numérique de signaux par la multiplication de valeurs d'entrée (x(k)) retardées et couplées à un premier signal d'horloge (f1) par des facteurs de pondération (Ci ; $C_l$) et par la sommation des valeurs multipliées qui dépendent d'une valeur de différence de temps ($\Delta t$ ; dt) qui est déterminée par l'instant de l'interpolation (tP) et par la trame de tranches de temps du premier signal d'horloge (f1),
   caractérisé par les caractéristiques suivantes :

   - au moyen d'une réponse impulsionnelle h(t) de l'intervalle de temps, on détermine les facteurs de pondération (Ci ; $C_l$), la fonction de transfert H(f) comportant, dans le domaine de fréquences, un procédé d'amortissement de signaux qui est limité, en ce qui concerne les bandes d'exclusion, aux domaines de perturbations (1S, 2S, ...pS, ...) se trouvant aux fréquences multiples du premier signal d'horloge (f1),
   - à chacun de ces domaines de perturbations (1S, 2S, ...pS, ...), on associe au moins deux zéros de la fonction de transfert H(f) dans le domaine de fréquences,
   - les au moins deux zéros de chaque domaine de pertubations sont l'un à côté de l'autre ou
   - à au moins un des domaines de perturbations (pS), on associe un autre zéro de la fonction de transfert H(f) lorsque les deux zéros se suivent en tant que zéros du deuxième ordre (K = 2).

2. Procédé selon la revendication 1, caractérisé en ce que l'on forme, à partir d'une réponse impulsionnelle initiale $h_{alt}(t)$, selon la règle de calcul suivante :

$$h(t) = h_{neu}(t) = h_{alt}(t) + h_{alt}(t - ta) \text{ dans laquelle } ta = 1 / 2fn$$

une nouvelle réponse impulsionnelle h(t) pour laquelle le premier autre zéro de la fonction de transfert H(f) doit se trouver à un fréquence prédéterminée fn.

3. Procédé selon la revendication 2, caractérisé en ce que l'on peut positionner de manière arbitraire d'autres zéros supplémentaires de la fonction de transfert H(f) par une utilisation répétée du procédé selon la revendication 2.

4. Procédé selon la revendication 1, caractérisé en ce que, à chaque domaine de perturbations (1S, 2S, ..., pS, ...), on associe au moins un autre zéro de la fonction de transfert H(f) dans le domaine de fréquences de telle manière que tous les domaines de perturbations comportent au moins trois zéros.

**12**

5. Procédé selon la revendication 4, caractérisé en ce que les au moins trois zéros médians par rapport aux domaines de perturbations respectifs (1S, ..., pS, ...) se trouvent aux fréquences multiples (1f1, 2f1, ..., pf1, ...) du premier signal d'horloge (f1).

6. Procédé selon la revendication 5, caractérisé en ce que la réponse impulsionnelle h(t) d'une fonction d'interrogation et de maintien hn(t) ou h(K = n) comportant des zéros médians qui sont au moins de l'ordre $K = n = 3$, est définie par la formule suivante

$$hn(t) = \frac{1}{(n\text{-}1)!} \times \sum_{k=0}^{n} [\binom{n}{k} \times (\text{-}1)^k \times (t\text{-}kT1)^{n\text{-}1} \times \sigma(t\text{-}kT1)]$$

dans laquelle :

"n" est l'ordre des zéros médians de la fonction de transfert Hn(f),
"k" est une valeur courante de nombre pour la sommation qui peut prendre les valeurs zéro à n, et
"σ(t)" ou "σ(t -kT1)" est un échelon unité à l'instant t ou à l'instant retardé t-kT1.

7. Procédé selon la revendication 6, caractérisé en ce que, à partir d'une ancienne réponse impulsionnelle $h_{alt}(t)$, on forme une nouvelle réponse impulsionnelle initiale $h_{neu}(t)$, conformément à un des procédés de la revendication 2 ou de la revendication 3.

8. Procédé selon la revendication 1, caractérisé en ce que, à partir d'une à partir d'une fonction de transfert initiale $H_{alt}(f)$, on forme, par un décalage dans le domaine de fréquences selon les valeurs $+ \Delta f$ et $- \Delta f$, une nouvelle lonction de transfert $H_{neu}(f)$, conformément à la formule suivante :

$$H_{neu}(f) = H_{alt}(f - \Delta f) \cdot H_{alt}(f + \Delta f)$$

grâce à quoi, la bande d'exclusion respective est élargie par rapport une à une position médiane de zéro.

9. Procédé selon l'une quelconque des revendications 1 à 7, caractérisé en ce que l'on produit des zéros supplémentaires de la fonction de transfert H(f) par répétition du procédé selon la revendication 8.

10. Procédé selon l'une quelconque des revendications 1 à 7, caractérisé en ce que les facteurs de pondération ($C_0$, ..., $C_{L-1}$) sont formés au moyen d'un étage à matrice (mx ; mxx).

11. Procédé selon l'une quelconque des revendications 1 à 7 ou selon la revendication 10, caractérisé en ce que la réponse impulsionnelle h(t) destinée au calcul des facteurs de pondération (Ci ; $C_I$ ; $C_0$, ..., $C_{L-1}$) est définie par sections par rapport à la différence de temps (dt).

12. Procédé selon l'une quelconque des revendications 1 à 7 et/ou selon l'une des revendications 10 ou 11, caractérisé en ce que la réponse impulsionnelle h(t) est réalisée au moyen d'une structure de filtre à réponse impulsionnelle finie (FIR), les facteurs de pondération étant formés au moyen d'un étage à matrice (mx ; mxx).

13. Procédé selon la revendication 12, caractérisé en ce que les facteurs de pondération sont formés, dans ce cas d'une réponse impulsionnelle h(t) définie par sections, au moyen d'un étage à matrice (mxx) pouvant être commuté.

13

FIG.1

FIG.3

FIG. 2

FIG. 4

FIG. 6

FIG. 5

EP 0 696 848 B1

FIG.7

H(f)

a / dB

0

-10

-20

-30

-40

-50

f / f1

$H_{SH}$

$H_{SH} + ta1$

$H_{SH} + ta1 + ta2$

FIG. 8

a/dB

0

H1(f) = H(K=1)

-20

H2(f)

-40

-60

0        1        2        3        4        f/f1

h(t)

h(K=2)

0,8

h2(t)

0,6

0,4

0,2

-0,5      0       0,5      1       1,5      2       t/T1

FIG. 9

FIG.10

FIG.11

FIG.12

FIG. 13